# EUROPÄISCHE PATENTSCHRIFT

(11) **EP 1 815 502 B1**
(45) Veröffentlichungstag und Bekanntmachung des Hinweises auf die Patenterteilung: **16.11.2011**
(21) Anmeldenummer: 05806379.3
(22) Anmeldetag: 28.10.2005
(51) Int. Cl.: H01L 21/00

(54) **VERFAHREN UND VORRICHTUNG ZUM BEHANDELN VON SUBSTRATEN UND DÜSENEINHEIT HIERFÜR**
METHOD AND DEVICE FOR TREATING SUBSTRATES AND CORRESPONDING NOZZLE UNIT
PROCEDE ET DISPOSITIF POUR TRAITER DES SUBSTRATS ET UNITE A BUSES UTILISEE A CET EFFET

(30) Priorität: 04.11.2004 DE 102004053337
(43) Veröffentlichungstag der Anmeldung: 08.08.2007
(73) Patentinhaber: HamaTech APE GmbH & Co. KG, 75447 Sternenfels (DE)
(72) Erfinder: BRANZ, Karsten, 88451 Dettingen (DE); DRESS, Peter, 76646 Bruchsal (DE); SOWA, Michael, c/o Hamatech Ape GmbH & Co. Kg, 75447 Sternenfels (DE); GAIRING, Thomas, 74321 Bietigheim (DE)
(74) Vertreter: Wagner & Geyer
(86) Internationale Anmeldenummer: PCT/EP2005/011533
(87) Internationale Veröffentlichungsnummer: WO 2006/048185

(56) Entgegenhaltungen:
- EP-A- 1 076 356
- US-A1- 2002 185 164

## Beschreibung

Die vorliegende Erfindung bezieht sich auf ein Verfahren und eine Vorrichtung zum Behandeln von Substraten sowie auf eine Düseneinheit hierfür. Insbesondere bezieht sich die vorliegende Erfindung auf ein Verfahren und eine Vorrichtung zur Oberflächenbehandelung von Substraten, insbesondere von Substraten in der Halbleitertechnologie, mit einer Flüssigkeit in Kombination mit Ultraschall, insbesondere mit Megaschall.

In unterschiedlichsten Technologiebereichen ist es bekannt, Komponenten mit Ultraschall zu reinigen. Hierbei werden die zu reinigenden Komponenten mit einem flüssigen Medium in Kontakt gebracht, üblicherweise eingetaucht, und für einen bestimmten Zeitraum mit Ultraschall beschallt, um Verunreinigungen zu lösen. Auch im Bereich der Wafer- und Maskenherstellung ist die Ultraschallreinigung eine anerkannte Technik und wird bereits auf unterschiedlichste Art und Weise eingesetzt.

Ein Ultraschallsystem besteht im Allgemeinen aus einem Generator und einem Ultraschallwandler, wobei der Generator eine Wechselspannung in eine entsprechende Betriebsspannung des Ultraschallwandlers umwandelt. Dieser wandelt wiederum die elektrische Energie in mechanische Schwingungen um, die in einem hiermit in Kontakt stehenden flüssigen Medium Über- und Unterdruckphasen entstehen lassen. Durch die abwechselnden Über- und Unterdruckphasen werden so genannten Kavitationsblasen erzeugt, die beim Implodieren kurzzeitig sehr hohe örtliche Drücke und Temperaturen entstehen lassen. Die Kavitationsblasen sind Grundlagen der Ultraschall-Reinigungstechnik. Bei einer Frequenz oberhalb 400 kHz spricht man von Ultraschall, und ab einer Frequenz von 700 kHz von Megaschall. Im Bereich der Megaschallfrequenzen ist die Kavitationsenergie vergleichsweise gering, so dass die Zerstörung von Mikrostrukturen vermieden wird. Gleichzeitig ist jedoch die Reinigungseffizienz im Bereich der Megaschallfrequenz bei kleinsten Partikeln sehr hoch. Daher wird bei der Wafer- und Maskenherstellung üblicherweise Megaschall eingesetzt.

Bei einem bekannten Ultraschall-Reinigungssystem, wie es beispielsweise in der DE-A-197 58 267 beschrieben ist, werden Halbleiterwafer als Charge in ein mit Flüssigkeit gefülltes Behandlungsbecken eingesetzt und anschließend mit Ultraschall beschallt. Dabei sind die Ultraschallwellen im Wesentlichen parallel zur Oberfläche der Wafer gerichtet und die gesamte Oberfläche der Wafer soll im Wesentlichen gleichmäßig behandelt werden.

Aus der US 2002/0185164 A1 ist ferner eine Vorrichtung und ein Verfahren zum Nassreinigen von Halbleiterwafern bekannt, nachdem sie in einer Schneidvorrichtung zugeschnitten wurden. Die Vorrichtung besitzt eine kombinierte Düsen- und Ultraschallwandleranordnung. Bei der kombinierten Anordnung ist ein Ultraschallwandler mittig zwischen zwei Reihen von Flüssigkeitsdüsen angeordnet, welche dazu dienen, einen Flüssigkeitsfilm auf einem zu reinigenden Halbleiterwafer aufzubringen. Die Ultraschallwandleranordnung wird mit dem Flüssigkeitsfilm in Kontakt gebracht und über die Wandleranordnung wird Ultraschall in den Flüssigkeitsfilm eingebracht, um den Halbleiterwafer zu reinigen.

Auch aus der EP 1 076 356 A2 ist eine Nassbehandlungsvorrichtung bekannt, die zwei Flüssigkeitsdüsen mit einem dazwischen angeordneten Ultraschall-Oszillator aufweist.

Ausgehend von einem derartigen Stand der Technik liegt der vorliegenden Erfindung die Aufgabe zugrunde, Ultraschall-, insbesondere Megaschallbehandlungsprozesse, zu optimieren.

Zur Lösung dieser Aufgabe sieht die vorliegende Erfindung ein Verfahren zur Behandlung von Substraten nach Anspruch 1 oder 44 vor. Ferner ist eine Vorrichtung zum Behandeln von Substraten mit einer Flüssigkeit und Ultra- oder Megaschall nach Anspruch 24, sowie eine Düseneinheit nach Anspruch 39 vorgesehen. Weitere Ausgestaltungen der Erfindung ergeben sich aus den Unteransprüchen.

Bei einem Verfahren zur Behandlung von Substraten wird ein Flüssigkeitsfilm auf einem lokal begrenzten Oberflächenbereich des zu behandelnden Substrats durch ein Düseneinheit ausgebildet wird, die wenigstens eine langgestreckte Düsenanordnung und einer benachbart dazu angeordnete Ultraschallwandleranordnung, insbesondere eine Megaschallwandleranordnung aufweist, die aus einer Vielzahl von Wandlern aufgebaut ist, die Wandler mit unterschiedlichen Resonanzfrequenzen aufweist. Wenigsten ein Teil der Ultraschallwandleranordnung wird mit dem Flüssigkeitsfilm in Kontakt gebracht und anschließend wird Ultraschall, insbesondere Megaschall, in den so ausgebildeten Flüssigkeitsfilm eingebracht, wobei die Wandler individuell und/oder in Gruppen mit unterschiedlichen Intensitäten und/oder Frequenzen angesteuert werden. Das erfindungsgemäße Verfahren ist für den Einsatz von Ultraschall geeignet, wobei bevorzugt Schall im Bereich der Megaschallfrequenzen eingesetzt wird. Dieses Verfahren ermöglicht eine lokal begrenzte Behandlung mit Flüssigkeit und Ultraschall von Oberflächenbereichen eines zu behandelnden Substrats, die für diesen bestimmten Oberflächenbereich optimiert werden kann. Ferner kann durch das lokale aufbringen eines Flüssigkeitsfilms eine Behandlung mit einer geringen Flüssigkeitsmenge erreicht werden, wodurch der Medienverbrauch minimiert werden kann. Dabei sei bemerkt, dass die Oberfläche des Substrats vor dem lokalen Aufbringen des Flüssigkeitsfilms schon wenigstens teilweise mit einer Flüssigkeit benetzt sein kann, und dass zusätzlich zu dem Ausbilden eines lokalen Flüssigkeitsfilms über die Düsenanordnung zusätzlich Flüssigkeit auf das Substrat aufgebracht werden kann. Ferner sei bemerkt, dass sich der Flüssigkeitsfilm nach dem lokalen Ausbilden verteilen und somit größere Teilbereiche und gegebenenfalls die gesamte Oberfläche des Substrats abdecken kann. Der Flüssigkeitsfilm kann sowohl durch Flüssigkeiten im klassischen Sinn als auch durch ein Medium im superkritischen Zustand gebildet werden. Der Aufbau der Ultraschallwandleranordnung aus einer Vielzahl von Ultraschallwandlern aufgebaut, die individuell und/oder in Gruppen angesteuert werden, ermöglicht innerhalb des lokal begrenzten Flüssigkeitsfilm einen unterschiedlichen Ultraschalleintrag und somit eine lokal optimierte Behandlung vorzusehen. Dies gilt insbesondere, wenn sich der Flüssigkeitsfilm über einen größeren Oberflächenbereich des Substrats, wie beispielsweise die gesamte Breite des Substrats erstreckt. Dabei ermöglicht die individuelle oder gruppenweise Ansteuerung der Ultraschallwandler eine über die Breite des Substrats optimierte Behandlung. Die Wandler mit unterschiedlichen Resonanzfrequenzen ermöglichen eine lokal unterschiedlich Behandlung vorzusehen. Dabei werden die Ultraschallwandler mit unterschiedlichen Intensitäten und/oder Frequenzen angesteuert, um eine individuelle Optimierung bzw. Anpassung der Wandler zu ermöglichen.

Bei einer bevorzugten Ausführungsform der Erfindung wird der Flüssigkeitsfilm zwischen einer im Wesentlichen geschlossenen Bodenstruktur der Düseneinheit und dem zu behandelnden Oberflächenbereich des Substrats gebildet, um einen gut definierten, homogenen Flüssigkeitsfilm ausbilden zu können, was wiederum eine definierte Ultraschallbehandlung fördert.

Vorzugsweise wird eine Relativbewegung zwischen der Düseneinheit und dem Substrat erzeugt, um das Aufbringen des Flüssigkeitsfilms auf unterschiedliche Oberflächenbereiche des Substrats und das Einbringen des Ultraschalls in den Flüssigkeitsfilm in diesen Bereichen zu ermöglichen. Hierdurch wird eine großflächige, gegebenenfalls vollständige Behandlung der Oberfläche des Substrats ermöglicht, wobei es möglich ist, die Behandlung mit der Flüssigkeit und Ultraschall für unterschiedliche Oberflächenbereiche zu optimieren. Eine derartige Optimierung ist beispielsweise möglich, indem die Relativbewegung zwischen der Düseneinheit und dem Substrat verändert wird, wodurch die Einwirkzeit des Flüssigkeitsfilms und des Ultraschalls verändert wird, dabei wird die Geschwindigkeit der Relativbewegung vorzugsweise in Abhängigkeit von der Position der Düseneinheit relativ zum Substrat verändert.

Als eine weitere Möglichkeit der Optimierung der Behandlung ist es möglich, die Einbringung des Ultraschalls in den Flüssigkeitsfilm während der Behandlung zu verändern. Dabei kann beispielsweise die Einbringung des Ultraschalls in Abhängigkeit von der Position der Düseneinheit relativ zum Substrat verändert werden. Bei einer Ausführungsform der Erfindung kann dabei die Intensität und/oder die Frequenz des in dem Flüssigkeitsfilms eingebrachten Ultraschalls verändert werden, um die Ultraschallwirkung auf den Oberflächenbereich entsprechend zu verändern. Als eine Frequenzänderung ist hier eine relativ geringe Abweichung bezüglich der Resonanzfrequenz eines Wandlers gemeint, um diesen zu verstimmen und somit das Effektivitätsprofil des Wandlers zu verändern.

Bei einer weiteren Ausführungsform der Erfindung lässt sich vorzugsweise der Einfallswinkel des Ultraschalls auf das Substrat durch eine Schrägstellung der Ultraschallwandleranordnung bezüglich einer Oberfläche des Substrats verändern. Dabei wird der Einfallswinkel des Ultraschalls bezüglich der Oberfläche des Substrats vorzugsweise zwischen 105° und 75° verändert. Sowohl die Intensität- und/oder Frequenzänderung des Ultraschalls als auch die Änderung des Einfallswinkels des Ultraschalls kann zu einer gezielten Kavitationsbildung direkt auf der Oberfläche des Substrats eingesetzt werden. Allerdings ist auch eine absichtliche Verstimmung des Effektivitätsprofils möglich, um eine Kavitationsbildung, beispielsweise beabstandet zur Substratoberfläche vorzusehen, um beispielsweise empfindliche Oberflächenstrukturen zu schützen. Hierdurch kann eine Optimierung der Behandlung ohne Strukturzerstörung vorgesehen werden.

Vorzugsweise wird der Flüssigkeitsfilm im Wesentlichen entlang einer Geraden über die gesamte Breite des Substrats ausgebildet und der Ultraschall im Wesentlichen entlang einer Geraden über die gesamte Breite des Substrats in den Flüssigkeitsfilm eingebracht. Dies ermöglicht durch eine einzige Bewegung der Düseneinheit über das Substrat hinweg - bei entsprechender Ansteuerung der Düsenanordnung(en) und der Ultraschallwandleranordnung - die vollständige Behandlung der Oberfläche des Substrats bei guter lokaler Optimierung des Behandlungsprozesses. Dabei wird vorzugsweise zur lokalen Optimierung des Behandlungsvorgangs die Einbringung des Ultraschalls über die Breite des Substrats hinweg unterschiedlich gesteuert.

Für eine weitere Anpassung oder Optimierung des Behandlungsprozesses wird die Zusammensetzung der den Flüssigkeitsfilm bildenden Flüssigkeit gesteuert. Für eine lokale Optimierung weist die Düsenanordnung vorzugsweise eine Vielzahl von Düsen auf, die unterschiedlich angesteuert werden, was entlang der Düsenanordnung eine lokale Änderung des Behandlungsprozesses ermöglicht. Dabei werden vorzugsweise entlang der Düsenanordnung lokal unterschiedliche Flüssigkeiten und/oder Flüssigkeitsmengen zur Bildung des Flüssigkeitsfilmes auf das Substrat aufgebracht. Als unterschiedliche Flüssigkeiten sind insbesondere auch Flüssigkeiten mit unterschiedlichen Konzentrationen eines Bestandteils gemeint.

Bei dem bevorzugten Ausführungsbeispiel der vorliegenden Erfindung wird der Flüssigkeitsfilm durch wenigstens zwei Düsenanordnungen aufgebracht, die auf entgegengesetzten Seiten der Wandleranordnung angeordnet sind, um eine gute homogene Ausbildung des Flüssigkeitsfilms im Bereich der Wandleranordnung sicherzustellen. Bei einer Ausführungsform der Erfindung werden die auf entgegengesetzten Seiten der Wandleranordnung angeordneten Düsen mit unterschiedlichen Flüssigkeit beaufschlagt.

Vorzugsweise wird während der Behandlung ein mittlerer Abstand von 0,2 bis 2 mm, insbesondere von 0,7 bis 1,4 mm zwischen der Ultraschallwandleranordnung und der zu behandelnden Oberfläche des Substrats beibehalten. Dabei kann der Abstand beispielsweise während der Behandlung verändert werden, um wiederum eine Änderung der Behandlung, insbesondere lokale Änderungen, vorzusehen.

Bei einer besonders bevorzugten Ausführungsform der Erfindung enthält die den Flüssigkeitsfilm bildende Flüssigkeit einen Entwickler oder ein Ätzmittel, wobei der Ultraschall in diesem Fall einen guten Kontakt der Oberfläche des zu behandelnden Substrats und dem Behandlungsmedium sicherstellt, indem verhindert wird, dass sich Partikel auf der Oberfläche absetzen. Ferner bewirkt der Ultraschall eine gute Durchmischung des Entwicklers, sodass eine lokale Sättigung der Flüssigkeit vermieden werden kann.

Bei einer weiteren Ausführungsform der Erfindung enthält die den Flüssigkeitsfilm bildende Flüssigkeit vorzugsweise ein Spül- und/oder Reinigungsflüssigkeit, wobei der Ultraschall hierbei die Reinigungswirkung fördert.

Die Vorrichtung zum Behandeln von Substraten besitzt eine Düseneinheit mit wenigstens einer langgestreckten Düsenanordnung und einer benachbart zur Düsenanordnung angeordneten langgestreckten Ultraschallwandleranordnung, insbesondere eine Megaschall-Wandleranordnung, die aus einer Vielzahl von Wandlern aufgebaut ist und Wandler mit unterschiedlichen Resonanzfrequenzen aufweist.Die wenigstens eine Düsenanordnung und die Ultraschallwandleranordnung weisen im Wesentlichen in dieselbe Richtung. Ferner ist eine Bewegungseinrichtung für das Substrat und/oder die Düseneinheit zum Positionieren derselben benachbart zu einer Oberfläche des Substrats derart vorgesehen ist, dass die wenigstens eine Düsenanordnung und die Ultraschallwandleranordnung mit einem definierten Abstand auf die Oberfläche des Substrats gerichtet sind, sowie eine Steuervorrichtung zum einzelnen und/oder gruppenweisen Ansteuern der Vielzahl von Wandlern. Diese Vorrichtung ermöglicht das lokale Aufbringen eines Flüssigkeitsfilms auf einen Oberflächenbereich eines zu behandelnden Substrats und eine gleichzeitige anschließende lokal optimierte Ultraschallbehandlung im Bereich des Flüssigkeitsfilms.

Vorzugsweise weist die Vorrichtung eine Steuervorrichtung zum Steuern einer Bewegungseinrichtung derart auf, dass die Düsenanordnung und die Ultraschallwandleranordnung mit einem definierten Abstand über die Oberfläche des Substrats hinwegbewegt wird, um sukzessive verschiedene Oberflächenbereiche des Substrats und insbesondere eine sukzessive Behandlung der gesamten Oberfläche des Substrats ermöglicht, wobei die sukzessive Behandlung unter Berücksichtigung der Oberflächenstruktur des Substrats und/oder des gewünschten Behandlungsergebnisses jeweils lokal angepasst werden kann.

Bei einer bevorzugten Ausführungsform der Erfindung ist wenigstens eine weitere langgestreckte Düsenanordnung vorgesehen, wobei die Ultraschallwandleranordnung zwischen wenigstens zwei langgestreckten Düsenanordnungen angeordnet ist. Das Vorsehen zweier langgestreckter Düsenanordnungen auf gegenüberliegenden Seiten der Ultraschallwandleranordnung fördert die Ausbildung eines definierten Flüssigkeitsfilms im Bereich der Ultraschallwandleranordnung. Für eine definierte Ausbildung eines solchen Flüssigkeitsfilms sind die wenigstens zwei langgestreckten Düsenanordnungen vorzugsweise zu einer Längsmittelebene der Ultraschallwandleranordnung hin gerichtet.

Vorzugsweise ist die Steuervorrichtung zum einzelnen und/oder gruppenweisen Ansteuern der Vielzahl von Ultraschallwandlern geeignet die Frequenz bzw. der Ansteuerleistung der Ultraschallwandler zu verändern.

Für eine Einstellung von Behandlungsparametern ist vorzugsweise eine Einrichtung zum Einstellen eines Winkels zwischen einer Oberfläche der Wandleranordnung und einer Oberfläche des Substrats vorgesehen. Hierdurch lässt sich der Einfallswinkel der Ultraschallwellen auf der Oberfläche des Substrats einstellen. Dabei ist der Winkel vorzugsweise zwischen 0° und 10° einstellbar.

Bei einer Ausführungsform der Erfindung ist der definierte Abstand zwischen 0,7 und 1,4 mm einstellbar.

Bei einer bevorzugten Ausführungsform der Erfindung ist eine Vorrichtung zum Liefern von Flüssigkeit an wenigstens eine Düsenanordnung vorgesehen zur Ausbildung eines Flüssigkeitsfilms auf einer zu behandelnden Oberfläche eines Substrats. Dabei ist vorzugsweise eine Steuervorrichtung zum Bereitstellen unterschiedlicher Flüssigkeiten für unterschiedliche Düsenanordnungen und/oder unterschiedliche Auslassdüsen der Düsenanordnung(en) vorgesehen, was eine lokale Anpassung der Behandlung über die Ausdehnung der Düsenanordnung hinweg ermöglicht.

Bei einer besonders bevorzugten Ausführungsform der Erfindung sind die wenigstens eine Düsenanordnung und die Ultraschallwandleranordnung in/an einem gemeinsamen Hauptkörper der Düseneinheiten vorgesehen und bilden eine im Wesentlichen geschlossene Bodenstruktur. Dies fördert die Ausbildung eines Flüssigkeitsfilms zwischen zwei sich gegenüberliegenden geschlossenen Strukturen, das heißt der Oberfläche des Substrats und der geschlossenen Bodenstruktur der Düseneinheit. Dabei steht die im Wesentlichen geschlossene Bodenstruktur im Bereich der Ultraschallanordnung bezüglich dem Rest der Bodenstruktur vor, wodurch eine gute Kontaktierung der Ultraschallanordnung mit einem Flüssigkeitsfilm vorgesehen wird, der zwischen einer Oberfläche des zu behandelnden Substrats und der Bodenstruktur ausgebildet wird.

Die Düseneinheit besitzt wenigstens eine langgestreckte Düsenanordnung und eine benachbart zur Düsenanordnung angeordnete langgestreckte Ultraschallwandleranordnung, insbesondere einer Megaschall-Wandleranordnung, die aus einer Vielzahl von Wandlern aufgebaut ist, die Wandler mit unterschiedlichen Resonanzfrequenzen aufweist, sowie eine Steuereinheit zum einzelnen und/oder gruppenweisen Ansteuern der Vielzahl von Wandlern. Die Düsenanordnung und die Ultraschallwandleranordnung weisen in dieselbe Richtung und bilden eine geschlossene Bodenstruktur der Düseneinheit. Eine derartige Düseneinheit ermöglicht auf einfache Weise die Ausbildung eines definierten Flüssigkeitsfilms zwischen einer Oberfläche des Substrats und der geschlossenen Bodenstruktur der Düseneinheit und das gezielte lokal optimierte einbringen von Ultraschall in einen derart gebildeten Flüssigkeitsfilm.

Vorzugsweise ist wenigstens eine weitere langgestreckte Düsenanordnung vorgesehen, wobei die Ultraschallwandleranordnung zwischen den wenigstens zwei langgestreckten Düsenanordnungen angeordnet ist, wodurch eine Flüssigkeitszufuhr von beiden Seiten der Ultraschallwandleranordnung und somit eine homogene Ausbildung eines Flüssigkeitsfilms gefördert wird. Dabei ist die wenigstens eine langgestreckte Düsenanordnung zu einer Mittelebene der Ultraschallwandleranordnung hin gerichtet, um eine gezielte Ausbildung eines Flüssigkeitsfilms im Bereich der Ultraschallwandleranordnung zu fördern.

Die Ultraschallwandler sind vorzugsweise jeweils direkt benachbart zueinander in einer Reihe oder in Form einer Matrix angeordnet. Dies ermöglicht eine gute separate Ansteuerung der Ultraschallwandler und somit eine örtliche Einstellung von Behandlungsparametern während einer Behandlung einer Substratoberfläche mit einer Flüssigkeit und Ultraschall.

Die vorliegende Erfindung wird nachfolgend anhand eines Ausführungsbeispiels unter Bezugnahme auf die Zeichnungen noch näher erläutert; in den Zeichnungen zeigt:
- Fig. 1.: eine schematische perspektivische Darstellung einer Düseneinheit gemäß der vorliegenden Erfindung in Relation zu einem zu behandelnden Substrat;
- Fig. 2: eine schematische Schnittdarstellung einer Düseneinheit gemäß der vorliegenden Erfindung;
- Fig. 3: eine schematische Ansicht von unten auf eine Düseneinheit gemäß der vorliegenden Erfindung;
- Fig. 4 a und b: schematische Schnittdarstellungen einer Düseneinheit gemäß der vorliegenden Erfindung in unterschiedlichen Ausrichtungen bezüglich eines Substrats;
- Fig. 5: eine schematische Darstellung einer UltraschallwandlerAnordnung in Form einer flächenhaften Matrix gemäß einer Ausführungsform der Erfindung;
- Fig. 6: eine schematische Schnittdarstellung einer Düseneinheit der vorliegenden Erfindung gemäß einer alternativen Ausführungsform.

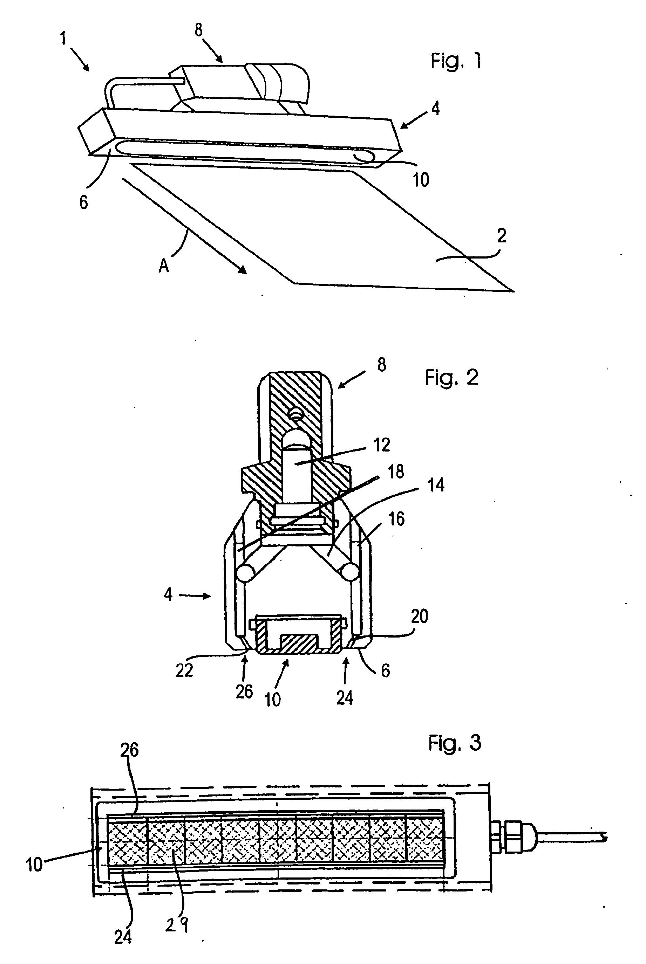

Fig. 1 zeigt eine perspektivische Ansicht einer Düseneinheit 1, die zur Behandlung eines Substrats 2 mit Flüssigkeit und Ultraschall einsetzbar ist. Während in dieser Anmeldung vorwiegend der begriff Ultraschall verwendet wird sei darauf hingewiesen, dass dies Megaschall umfassen soll, und die Erfindung insbesondere für eine Oberflächenbehandlung von Substraten mit Megaschall gedacht ist.

Die Düseneinheit 1 besitzt einen im Wesentlichen quaderförmigen Hauptkörper 4 mit einer Unterseite 6, in der eine Vielzahl von Auslassdüsen ausgebildet ist, wie nachfolgend noch näher erläutert ist. An der Oberseite des Hauptkörpers 4 ist eine Medienzuführeinheit 8 vorgesehen, die mit einer nicht dargestellten Medienversorgung in Verbindung steht, wie nachfolgend noch näher erläutert wird. Die Düseneinheit 1 ist über einen nicht dargestellten Bewegungsmechanismus, wie einen Linearbewegungsmechanismus in Richtung des Pfeils A über das Substrat 2 hinweg bewegbar. Im Bereich des Bodens 6 ist eine Ultraschallwandleranordnung 10 vorgesehen, deren Aufbau nachfolgend noch näher beschrieben wird.

Anhand der Fig. 2, die eine schematische Schnittansicht durch die Düseneinheit 1 darstellt, wird der Aufbau der Düseneinheit 1 noch näher erläutert. In einem oberen Abschnitt der Fig. 2 ist die Medienzufuhreinheit 8 dargestellt, die einen Medienverteilungsraum 12 aufweist, in dem beispielsweise unterschiedliche Medien eingeleitet und vermischt werden können. Der Medienverteilungsraum 12, der im Wesentlichen mittig oberhalb des quaderförmigen Hauptkörpers 4 vorgesehen ist, steht über entsprechende sich schräg im Hauptkörper 4 erstreckende Leitungen 14 mit sich im Wesentlichen senkrecht zur Unterseite 6 des Hauptkörpers 4 erstreckende Zuleitungen 16 bzw. 18 in Verbindung. Die Zuleitungen 16 bzw. 18 erstrecken sich parallel zu gegenüberliegenden Längsseiten des Hauptkörpers 4. Die jeweiligen Zuleitungen 16 bzw. 18 stehen an ihrem unteren Ende jeweils mit einer Vielzahl von Auslassbohrungen 20 bzw. 22 in Verbindung, die sich zur Unterseite 6 des Hauptkörpers 4 hin öffnen. Die Auslassbohrungen 20 bzw. 22 sind jeweils Bestandteil von Düsenanordnungen, die auf gegenüberliegenden Seiten der Ultraschallwandleranordnung 10 angeordnet sind, wie in Fig. 2 gut zu erkennen ist.

Die Düsenanordnungen 24, 26 und die Ultraschallwandleranordnung 10 besitzen eine Längsausdehnung, die wenigstens der Breite eines zu behandelnden Substrats entspricht, um in einem einzigen Überstreichvorgang eine vollständige Oberflächenbehandlung des Substrats zu ermöglichen.

Wie in Fig. 2 zu erkennen ist, steht die Ultraschallwandleranordnung bezüglich der Austrittsöffnungen der Auslassbohrungen 20 bzw. 22 vor. Die Unterseite 6 des Hauptkörpers 4 und die Ultraschallwandleranordnung bilden gemeinsam eine geschlossene Bodenstruktur der Düseneinheit 1.

Wie in Fig. 2 ferner zu erkennen ist, sind die Auslassbohrungen 20 bzw. 22 bezüglich einer Längsmittelebene des Hauptkörpers 4 geneigt und erstrecken sich ausgehend von den Zuleitungen 16 bzw. 18 in Richtung der Längsmittelebene. Aus den Auslassbohrungen 20 bzw. 22 austretende Flüssigkeiten werden somit in Richtung der Längsmittelebene gerichtet. Die Auslassbohrungen 20 bzw. 22 sind jeweils Teil von Düsenanordnungen 24, 26, die durch eine Vielzahl in der Blattebene hintereinander angeordneten Auslassbohrungen 20 bzw. 22 gebildet wird. Alternativ ist es auch möglich eine oder mehrere Schlitzdüsen anstelle der Auslassbohrungen vorzusehen. Auf der Rückseite der Ultraschallwandleranordnung 10 ist ein Kühlmittelkanal zum hindurchleiten eines Kühlmittels vorgesehen, um eine Kühlung der Ultraschallwandler vorzusehen. Eine Kühlung kann aber auch über einen zwischen einem zu reinigenden Substrat und der Düseneinheit vorgesehenen Flüssigkeitsfilm erfolgen.

Fig. 3 zeigt eine schematische Ansicht von untern auf die Düseneinheit 1, wobei in der Figur die Düsenanordnungen 24, 26 und die Ultraschallwandleranordnung 10 schematisch dargestellt sind. Wie in Fig. 3 zu erkennen ist, besteht die Ultraschallwandleranordnung 10 aus insgesamt 9 rechteckigen Ultraschallabstrahlelementen 29, die über eine nicht näher dargestellt Steuereinrichtung separat und/oder in Gruppen ansteuerbar sind. Somit ist über die Länge der Düseneinheit 1 eine unterschiedliche Ultraschallausbildung möglich, wie nachfolgend noch näher erläutert wird.

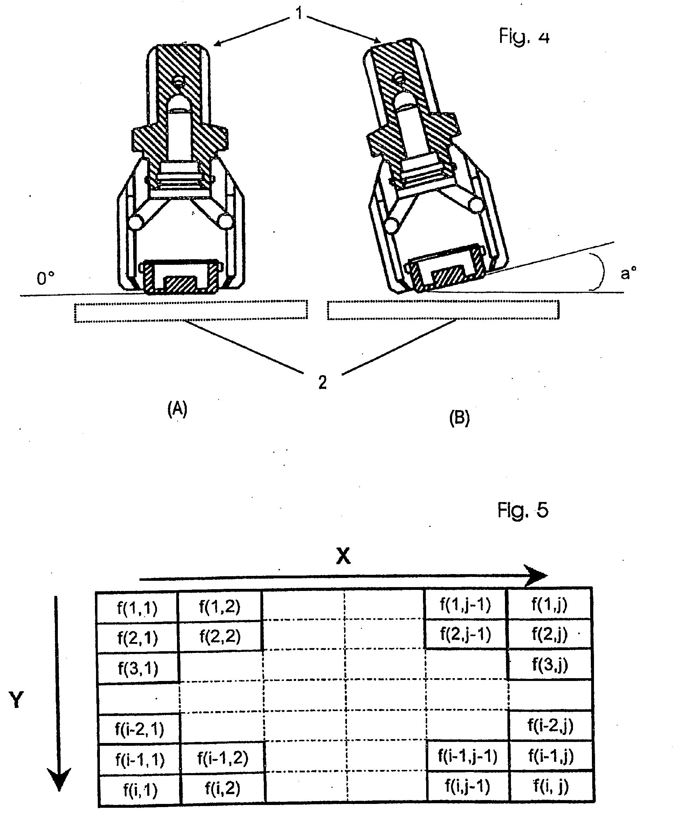

Die Figuren 4a und 4b zeigen jeweils eine unterschiedliche Anordnung der Düseneinheit 1 bezüglich eines Substrats 2.

Gemäß Fig. 4a ist die Düseneinheit 1 derart angeordnet, dass eine Unterseite der Ultraschallwandler-Anordnung 10 im Wesentlichen parallel zu einer Oberseite eines zu behandelnden Substrats 2 ausgerichtet ist. Fig. 4b zeigt hingegen eine Schrägstellung einer Unterseite der Ultraschallwandler-Anordnung 10 bezüglich einer Oberfläche eines zu behandelnden Substrats 2, wie durch den eingezeichneten Winkel a angedeutet ist. Dieser Winkel ist vorzugsweise zwischen 0° und 10° einstellbar, wie nachfolgend noch näher erläutert wird.

Fig. 5 zeigt eine alternative Anordnungsform für eine Ultraschallwandler-Anordnung, wobei eine Vielzahl von Ultraschallwandlern in Form einer Matrix in x- und y-Richtung angeordnet ist.

Nachfolgend wird die Funktionsweise der Düseneinheit 1 näher erläutert.

Zunächst wird die Düseneinheit über einen zu behandelnden Oberflächenbereich eines Substrats, in diesem Fall ein Halbleiterwafer der einem Entwicklungsprozess ausgesetzt wird, bewegt. Zwischen einer Unterseite der Düseneinheit 1 und einer Oberseite des Substrats 2 wird ein Abstand zwischen 0,7 und 1,4 mm eingestellt. Anschließend wird über die Medienzuführeinheit eine Entwicklerflüssigkeit in den Medienverteilungsraum 12 eingeleitet und über die Leitungen 14 und die Zuleitungen 16 bzw. 18 zu den jeweiligen Auslassbohrungen 20 bzw. 22 der Düsenanordnungen 24 bzw. 26 geleitet. Dabei handelt es sich um eine Entwicklerlösung mit einer vorbestimmten Konzentration, die über die Medienzuführeinheit 8 in bekannter Weise eingestellt wird.

In der folgenden Beschreibung gehen wir zunächst davon aus, dass die Unterseite der Wandleranordnung 10 parallel zur Oberseite des Substrats 2 ausgerichtet ist. Durch die aus den Düsenanordnungen 24, 26 austretende Flüssigkeit, die in Richtung zu einer Längsmittelachse der Düseneinheit 1 gerichtet ist, wird nunmehr ein Flüssigkeitsfilm zwischen der geschlossenen Bodenstruktur der Düseneinheit und der Oberfläche des Substrats ausgebildet. Der Flüssigkeitsfilm füllt den Abstand zwischen der Oberfläche des Substrats 2 und der Bodenstruktur der Düseneinheit 1 vollständig aus. Dadurch dass die Ultraschallwandler-Anordnung 10 bezüglich der restlichen Unterseite der Düseneinheit 1 vorsteht, ist ein vollständiger Kontakt zwischen der Ultraschallanordnung 10 und dem Flüssigkeitsfilm gegeben.

Anschließend wird die Ultraschallwandleranordnung 10 angesteuert, und es wird Ultraschall in den Flüssigkeitsfilm eingebracht, der senkrecht auf die Oberfläche des Substrats 2 gerichtet ist. Die Ultraschallwellen erzeugen nunmehr aufgrund des oben beschriebenen Kavitationseffekts ein Lösen von Partikeln von der Oberfläche des Substrats 2, wodurch eine gleichmäßige Entwicklung der Oberfläche des Substrats 2 sichergestellt wird. Insbesondere werden gelöste Lackpartikel durch die Ultraschallagitation aufgewirbelt, sodass ein guter und gleichmäßiger Kontakt der Entwicklerlösung mit ungelösten Lackschichten erreicht werden kann. Dies führt zu einer verbesserten Gleichmäßigkeit des Prozessergebnisses unabhängig von Strukturgrößenund Strukturdichtenverteilungen auf der Substratoberfläche. Ferner kann die Prozesszeit durch die Verbesserte Einwirkung des Entwicklers verkürzt werden, was auch Verringerung des Medienverbrauchs ermöglicht.

Nach einer vorbestimmten Behandlungszeit in dieser Position wird nunmehr die Düseneinheit 1 über das Substrat 2 hinwegbewegt, um die ultraschallunterstützte Behandlung mit der Entwicklerlösung sukzessive auf der gesamten Oberfläche des Substrats 2 vorzusehen. Natürlich ist es auch möglich, die ultraschallunterstützte Behandlung mit Entwicklungslösung nur in ausgewählten Oberflächenbereichen des Substrats vorzusehen.

Um eine gezielte und differenzierte Steuerung der Behandlung in unterschiedlichen Oberflächenbereichen des Substrats vorzusehen, sind bei den oben beschriebenen Grundverfahren unterschiedlichste Steuermöglichkeiten vorgesehen. Beispielsweise ist es möglich, die unterschiedlichen Ultraschallwandler der Ultraschallwandler-Anordnung 10, die beispielsweise wie in Fig. 3 oder in Fig. 5 angeordnet sein können, unterschiedlich anzusteuern. Dabei ist es möglich, dass einige der Ultraschallwandler als Sensoren eingesetzt werden, um den Energieeintrag benachbarter Ultraschallwandler in den Flüssigkeitsfilm zu detektieren. Dabei ist es natürlich auch möglich, die Ultraschallwandler zwischen einem Ultraschallabgabemodus und einem Sensormodus zu wechseln, sodass alle Ultraschallwandler über die Zeit hinweg als Sensor und Sender dienen können.

Durch die unterschiedliche Ansteuerung der Ultraschallwandler lassen sich über die Breit des Substrats hinweg unterschiedliche Behandlungsergebnisse erzielen. Dabei ist sowohl eine Ansteuerung mit unterschiedlichen Frequenzen sowie eine Ansteuerung mit unterschiedlicher Leistung möglich. So sind die einzelnen Ultraschallwandler beispielsweise mit einem Leistungsniveau von 0 % bis 100 % ihrer Maximalleistung ansteuerbar und die Ultraschallfrequenz ist vorzugsweise zwischen einem Megahertz und fünf Megahertz einstellbar.

Als weiterer Steuerparameter für die Oberflächenbehandlung ist es möglich, über die Länge der Düsenanordnung(en) 24 und/oder 26 hinweg unterschiedliche Flüssigkeiten und/oder unterschiedliche Flüssigkeitsmengen bereitzustellen. Beispielsweise lässt sich hierdurch in Randbereichen des Substrats eine Entwicklerlösung mit einer unterschiedlichen Konzentration im Vergleich zu einem Mittelbereich des Substrats zur Verfügung stellen. Auch ist es möglich, die aufgebrachte Flüssigkeit (Konzentration/Menge/Art) bei einem Überstreichen des Substrats zu verändern. Dadurch lassen sich lokal über die Länge des Substrats auf der Oberfläche des Substrats völlig unterschiedliche Behandlungsergebnisse erzielen. Auch ein vollständiger Austausch des verwendeten Mediums beispielsweise ein Austausch der Entwicklerlösung durch eine Spülflüssigkeit ist möglich.

Ein weiterer Steuerparameter gemäß der vorliegenden Erfindung ist der Einfallswinkel der Ultraschallwellen auf das Substrat, der, wie in Fig. 4 dargestellt ist, über eine Schrägstellung der Düseneinheit bezüglich der zu behandelnden Oberfläche des Substrats 2 erfolgt. Hierdurch lässt sich unter anderem auch der Energieeintrag der Ultraschallwellen in einem Flüssigkeitsfilm steuern, wenn die Ultraschallwandler beispielsweise nicht vollständig in den Flüssigkeitsfilm eingetaucht sind, da eine Übertragung der Ultraschallwellen nur dort stattfindet, wo die Ultraschallwandler den Flüssigkeitsfilm kontaktieren.

Eine weitere Steuermöglichkeit liegt in der Einstellung der Relativgeschwindigkeit zwischen der Düseneinheit und dem Substrat während des Überstreichens, wodurch die Verweilzeiten des Flüssigkeitsfilms und die Einwirkdauer der Ultraschallwellen lokal einstellbar sind.

Alle diese Steuermöglichkeiten ermöglichen eine Anpassung, insbesondere Optimierung einer Oberflächenbehandlung des Substrats in Abhängigkeit von lokalen Oberflächenbeschaffenheiten des Substrats bzw. in Abhängigkeit von einem gewünschten Prozessergebnis.

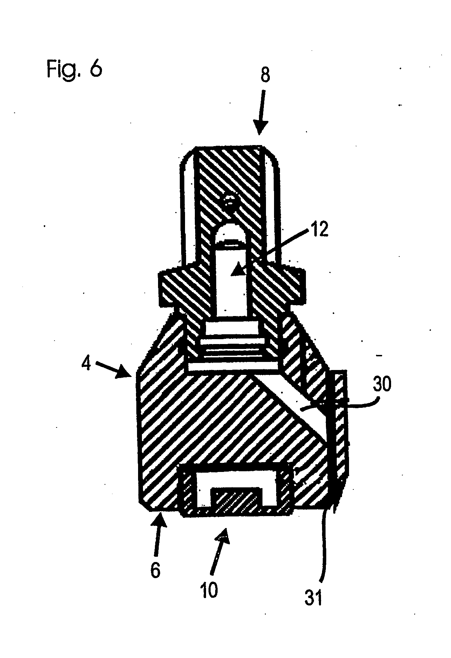

Fig. 6 zeigt eine schematische Schnittansicht einer Düseneinheit der vorliegenden Erfindung gemäß einer alternativen Ausführungsform. In Fig. 6 werden dieselben Bezugszeichen wie in den vorhergehenden Ausführungsbeispielen verwendet, sofern identische oder ähnliche Elemente beschrieben werden.

Die in Fig. 6 gezeigte Düseneinheit 1 besitzt wiederum einen Hauptkörper 4 mit einer Unterseite 6. In einer Ausnehmung der Unterseite 6 ist eine Ultraschallwandleranordnung 10 angeordnet. Die Düseneinheit 1 weist ferner eine Medienzuführeinheit 8 mit einen Medienverteilungsraum 12 auf, in den beispielsweise unterschiedliche Medien eingeleitet und vermischt werden können. Der Medienverteilungsraum 12, der im Wesentlichen mittig oberhalb des Hauptkörpers 4 vorgesehen ist, steht über eine Vielzahl von sich schräg im Hauptkörper 4 erstreckende Leitungen 30 in Verbindung. Die vom Medienverteilungsraum abgewandten Enden bilden jeweils Austrittsdüsen, die sich zu einer Seitenfläche 31 des Hauptkörpers 4 öffnen. Eine Prallplatte 32 erstreckt sich derart Im Wesentlichen parallel zur der Seitenfläche 31, dass aus den Düsen austretende Flüssigkeit auf die Prallplatte gelenkt wird und an dieser herabfließt. Zwischen der Seitenfläche 31 und der Prallplatte 32 ist ein kleiner Kapillarspalt vorgesehen, der sich vorzugsweise leicht nach unten erweitert. Aus den Düsen austretende Flüssigkeit strömt daher an der Prallplatte herab und bildet einen im Wesentlichen gleichförmigen Vorhang. Die Austrittsdüsen in der Seitenfläche 31 bilden gemeinsam mit der Prallplatte 32 eine Düsenanordnung. Dabei ist das untere Ende des Spalts zwischen der Prallplatte und der Seitenfläche 31 des Hauptkörpers 4 als eine Fluid-Austrittsöffnung der Düsenanordnung. Die Düsenanordnung und die Ultraschallwandleranordnung weisen somit im Wesentlichen in dieselbe Richtung, da sowohl eine aus der Düsenanordnung austretende Flüssigkeit als auch ein von der Ultraschallwandleranordnung ausgehender Ultraschall im Wesentlichen senkrecht zur Unterseite 6 des Hauptkörpers gerichtet sind.

Der Aufbau einer Düsenanordnung mit einer Prallplatte ist beispielsweise aus der auf die Anmelderin zurückgehenden, nicht vorveröffentlichten DE-A-102 32 984 bekannt, auf die insofern verwiesen wird, um Wiederholungen zu vermeiden.

Eine derartige Düseneinheit bietet den Vorteil, dass der auf ein Substrat aufgebrachte Flüssigkeitsfilm im Wesentlichen ohne Kraft darauf aufgebracht werden kann und ferner ermöglicht er eine gute gleichmäßige Ausbildung eines Flüssigkeitsfilms auf einem zu behandelnden Substrat.

Über die Länge der Prallplatte hinweg können wiederum über die Vielzahl von Leitungen 30 unterschiedliche Flüssigkeiten, insbesondere Flüssigkeiten mit unterschiedlicher Konzentrationen eines Entwicklers oder eines Ätzmittels innerhalb einer Trägerflüssigkeit, aufgebracht werden. Obwohl in Fig.6 nur eine Prallplatte vorgesehen ist, kann zur Bildung einer zweiten Düsenanordnung beispielsweise eine zweite Prallplatte an der der Seitenfläche 31 gegenüberliegenden Seitenfläche vorgesehen sein. Die zusätzliche Prallplatte könnte über entsprechende Leitungen, wie den Leitungen 30 mit Fluid beaufschlagt werden. Hierdurch wird ermöglicht, dass durch entsprechende Ansteuerung die Düseneinheit in unterschiedlichen Richtungen über das Substrat hinweg bewegt wird und in beiden Bewegungsrichtungen eine gute Ausbildung eines Flüssigkeitsfilms möglich ist. Ferner können über die Düsenanordnungen unterschiedliche Flüssigkeiten auf ein Substrat aufgebracht werden. Beispielsweise kann über eine in Bewegungsrichtung der Düseneinheit vorn liegende Düsenanordnung eine Entwicklerlösung aufgebracht werden, während über die in Bewegungsrichtung hinten liegende Düsenanordnung eine Neutralisierungslösung aufgebracht wird.

Die Funktionsweise der Düseneinheit 1, gemäß Fig. 6, gleicht im Wesentlichen der zuvor beschriebenen Funktionsweise der Düseneinheit gemäß den Figuren 1 bis 5, wobei bei der Düseneinheit 1 gemäß Fig. 6 Flüssigkeit nur entlang einer Linie aufgebracht wird, sofern nicht eine zweite Prallplatte vorgesehen ist.

Die unterschiedlichen oben genannten Aspekte der Erfindung können frei miteinander ausgetauscht und kombiniert werden.

Obwohl die vorliegende Erfindung anhand eines konkreten Ausführungsbeispiels beschrieben wurde, ist sie nicht auf die konkret dargestellte Ausführungsform beschränkt. Beispielsweise ist es nicht notwendig, dass sich die Düseneinheit und insbesondere die Düsenanordnungen 24,26 und die Ultraschallwandleranordnung über die gesamte Breite eines zu behandelnden Substrats erstrecken. Auch ist es beispielsweise möglich nur eine der Düsenanordnungen vorzusehen, sofern diese für die Ausbildung eines definierten Flüssigkeitsfilm auf einem zu behandelnden Substrat ausreicht. Statt eines linearen überstreichen des Substrats kann es beispielsweise auch im Rahmen einer Schwenkbewegung überstrichen werden. Natürlich ist es auch möglich, das Substrat an der Düseneinheit vorbei zu bewegen. Die Anwendung der Düseneinheit ist auch nicht auf eine Behandlung mit einem Entwickler beschränkt. Die Düseneinheit kann insbesondere auch für Ätzvorgänge und Spül- und/oder Reinigungsvorgänge eingesetzt werden. Auch sind solche Vorgänge hintereinander mit ein und derselben Düseneinheit möglich. Das erfindungsgemäße Verfahren ist insbesondere für Halbleiterwafer, Masken für die Halbleiterherstellung und LCD-Anzeigen geeignet.

## Patentansprüche

1. Verfahren zum Behandeln von Substraten mit folgenden Verfahrensschritten:
Ausbilden eines Flüssigkeitsfilms auf einem lokalen Oberflächenbereich des zu behandelnden Substrats durch eine Düseneinheit mit wenigstens einer langgestreckten Düsenanordnung und einer benachbart hierzu angeordneten Ultraschall- oder Megaschallwandleranordnung, die aus einer Vielzahl von Wandlern aufgebaut ist, die Wandler mit unterschiedlichen Resonanzfrequenzen aufweist;
Inkontaktbringen wenigstens eines Teils der Ultra- bzw. Megaschall-Wandleranordnung mit dem Flüssigkeitsfilms; und
Einbringen von Ultraschall in den ausgebildeten Flüssigkeitsfilm mit der Ultra- bzw. Megaschall-Wandleranordnung, wobei die Wandler individuell und/oder in Gruppen mit unterschiedlichen Intensitäten und/oder Frequenzen angesteuert werden.

2. Verfahren nach Anspruch 1, **dadurch gekennzeichnet, dass** der Flüssigkeitsfilm zwischen einer geschlossene Bodenstruktur der Düseneinheit und dem zu behandelnden Oberflächenbereich des Substrats gebildet wird.

3. Verfahren nach Anspruch 1 oder 2, **gekennzeichnet durch** Erzeugen einer Relativbewegung zwischen der Düseneinheit und dem Substrat zum Aufbringen des Flüssigkeitsfilms auf unterschiedliche Oberflächenbereiche des Substrats und zum Einbringen des Ultraschalls in diesen Bereichen.

4. Verfahren nach Anspruch 3, **dadurch gekennzeichnet, dass** die Geschwindigkeit der Relativbewegung zwischen der Düseneinheit und dem Substrat verändert wird.

5. Verfahren nach Anspruch 4, **dadurch gekennzeichnet, dass** die Geschwindigkeit der Relativbewegung in Abhängigkeit von der Position der Düseneinheit relativ zum Substrat verändert wird.

6. Verfahren nach einem der vorhergehenden Ansprüche, **dadurch gekennzeichnet, dass** die Einbringung des Ultraschalls in den Flüssigkeitsfilm während der Behandlung verändert wird.

7. Verfahren nach Anspruch 6, **dadurch gekennzeichnet, dass** die Einbringung des Ultraschalls in Abhängigkeit von der Position der Düseneinheit relativ zum Substrat verändert wird.

8. Verfahren nach Anspruch 6 oder 7, **dadurch gekennzeichnet, dass** die Intensität und/oder die Frequenz des in den Flüssigkeitsfilm eingebrachten Ultraschalls wenigstens in einem Teilbereich der Wandleranordnung verändert wird.

9. Verfahren nach einem der Ansprüche 6 bis 8, **dadurch gekennzeichnet, dass** der Einfallswinkel des Ultraschalls auf das Substrat durch eine Schrägstellung der Wandleranordnung bezüglich einer Oberfläche des Substrats verändert wird.

10. Verfahren nach Anspruch 7, **dadurch gekennzeichnet, dass** der Einfallswinkel des Ultraschalls bezüglich der Oberfläche des Substrats zwischen 105° und 75° verändert wird.

11. Verfahren nach einem der vorhergehenden Ansprüche , **dadurch gekennzeichnet, dass** die Wandler entlang einer Reihe oder in Form einer Matrix angeordnet sind.

12. Verfahren nach einem der vorhergehenden Ansprüche, **dadurch gekennzeichnet, dass** der Flüssigkeitsfilm entlang einer Geraden über die gesamte Breite des Substrats ausgebildet wird, und der Ultraschall entlang einer Geraden über die gesamte Breite des Substrats in den Flüssigkeitsfilm eingebracht wird.

13. Verfahren nach einem der vorhergehenden Ansprüche, **dadurch gekennzeichnet, dass** über die Breite des Substrats hinweg die Einbringung des Ultraschalls unterschiedlich gesteuert wird.

14. Verfahren nach einem der vorhergehenden Ansprüche, **dadurch gekennzeichnet, dass** die Zusammensetzung der den Flüssigkeitsfilm bildenden Flüssigkeit gesteuert wird.

15. Verfahren nach einem der vorhergehenden Ansprüche, **dadurch gekennzeichnet, dass** die Düsenanordnung aus einer Vielzahl von Düsen besteht, die unterschiedlich angesteuert werden.

16. Verfahren nach Anspruch 14 oder 15, **dadurch gekennzeichnet, dass** lokal unterschiedliche Flüssigkeiten und/oder unterschiedliche Flüssigkeitsmengen zur Bildung des Flüssigkeitsfilms auf das Substrat aufgebracht werden.

17. Verfahren nach einem der vorhergehenden Ansprüche, **dadurch gekennzeichnet, dass** der Flüssigkeitsfilm durch wenigstens zwei Düsenanordnungen aufgebracht wird, die auf entgegengesetzten Seiten der Wandleranordnung angeordnet sind.

18. Verfahren nach Anspruch 17, **dadurch gekennzeichnet, dass** die auf entgegengesetzten Seiten der Wandleranordnung angeordneten Düsen mit unterschiedlichen Flüssigkeiten beaufschlagt werden.

19. Verfahren nach einem der vorhergehenden Ansprüche, **dadurch gekennzeichnet, dass** während der Behandlung ein mittlerer Abstand von 0,2 bis 2,0 mm, insbesondere von 0,7 bis 1,4 mm, zwischen der Wandleranordnung und der zu behandelnden Oberfläche des Substrats beibehalten wird.

20. Verfahren nach Anspruch 19, **dadurch gekennzeichnet, dass** der mittlere Abstand während der Behandlung verändert wird.

21. Verfahren nach einem der vorhergehenden Ansprüche, **dadurch gekennzeichnet, dass** die den Flüssigkeitsfilm bildende Flüssigkeit einen Entwickler oder ein Ätzmittel enthält.

22. Verfahren nach einem der vorhergehenden Ansprüche, **dadurch gekennzeichnet, dass** der Flüssigkeitsfilm eine Spül- und/oder Reinigungsflüssigkeit enthält.

23. Verfahren nach einem der vorhergehenden Ansprüche, **dadurch gekennzeichnet, dass** wenigstens einer der Wandler während des Einbringens des Ultraschalls in den Flüssigkeitsfilm wenigstens Zeitweise derart angesteuert wird, dass er als Sensor arbeitet.

24. Vorrichtung zum Behandeln von Substraten (2) mit einer Flüssigkeit und Ultra- oder Megaschall, die Folgendes aufweist:
eine Düseneinheit (1) mit wenigstens einer langgestreckte Düsenanordnung (24, 26) zum Aufbringen eines Flüssigkeitsfilms auf das Substrat (2) und einer benachbart zur Düsenanordnung (24, 26) angeordneten Wandleranordnung (10) zum Einbringen von Ultra- oder Megaschall in einen auf dem Substrat (2) befindlichen Flüssigkeitsfilm, wobei die Wandleranordnung (10) aus einer Vielzahl von Ultra- oder Megaschall-Wandlern (29) gebildet ist, und Wandler (29) mit unterschiedlichen Resonanzfrequenzen vorgesehen sind, und wobei die wenigstens eine Düsenanordnung (24, 26) und die Wandleranordnung (10) in dieselbe Richtung weisen; und
eine Bewegungseinrichtung für das Substrat (2) und/oder die Düseneinheit (1) zum Positionieren derselben benachbart zu einer Oberfläche des Substrats (2) derart, dass die wenigstens eine Düsenanordnung (24, 26) und die Wandleranordnung (10) mit einem definierten Abstand auf die Oberfläche des Substrats (2) gerichtet sind, und die Wandleranordnung (10) einen auf der Oberfläche des Substrats (2) ausgebildeten Flüssigkeitsfilm kontaktiert; und
eine Steuervorrichtung zum einzelnen und/oder gruppenweisen Ansteuern der Vielzahl von Wandlern (29).

25. Vorrichtung nach Anspruch 24, **gekennzeichnet durch** eine Steuervorrichtung zum Steuern der Bewegungseinrichtung derart, dass die Düsenanordnung (24, 26) und die Wandleranordnung (10) mit einem definierten Abstand über die Oberfläche des Substrats (2) hinweg bewegt wird.

26. Vorrichtung nach Anspruch 24 oder 25, **gekennzeichnet durch** wenigstens eine weitere langgestreckte Düsenanordnung (26, 24), wobei die Wandleranordnung (10) zwischen wenigstens zwei langgestreckten Düsenanordnungen (24, 26) angeordnet ist.

27. Vorrichtung nach Anspruch 26, **dadurch gekennzeichnet, dass** wenigstens eine der langgestreckten Düsenanordnungen (24, 26) zu einer Mittelebene der Wandleranordnung (10) hin gerichtet ist.

28. Vorrichtung nach einem der Ansprüche 24 bis 27, **dadurch gekennzeichnet, dass** die Vielzahl von Wandlern (29), jeweils benachbart zueinander, in einer Reihe oder in Form einer Matrix angeordnet ist.

29. Vorrichtung nach einem der Ansprüche 24 bis 28, **gekennzeichnet durch** eine Steuervorrichtung zum Verändern der an die Wandler (29) angelegten Frequenz und/oder Energie.

30. Vorrichtung nach einem der Ansprüche 24 bis 29, **gekennzeichnet durch** eine Einrichtung zum Einstellen eines Winkels zwischen einer Oberfläche der Wandleranordnung (10) und einer Oberfläche des Substrats (2).

31. Vorrichtung nach Anspruch 30, wobei der Winkel zwischen 0 und ±15° einstellbar ist.

32. Vorrichtung nach einem der Ansprüche 24 bis 31, **dadurch gekennzeichnet, dass** der definierte mittlere Abstand zwischen 0,2 und 2 mm, insbesondere zwischen 0,7 und 1,4 mm, einstellbar ist.

33. Vorrichtung nach einem der Ansprüche 24 bis 32, **gekennzeichnet durch** eine Vorrichtung zum Liefern von Flüssigkeit an die wenigstens eine Düsenanordnung (24, 26).

34. Vorrichtung nach Anspruch 33, **gekennzeichnet durch** eine Steuereinrichtung zum Bereitstellen unterschiedlicher Flüssigkeiten für unterschiedliche Düsenanordnungen (24, 26) und/oder unterschiedliche Auslassdüsen der Düsenanordnung(en) (24, 26).

35. Vorrichtung nach einem der Ansprüche 24 bis 34, **dadurch gekennzeichnet, dass** die wenigstens eine Düsenanordnung (24, 26) und die Wandleranordnung (10) in/an einem gemeinsamen Hauptkörper (4) vorgesehen sind, und eine geschlossene Bodenstruktur bilden,

36. Vorrichtung nach Anspruch 35, **dadurch gekennzeichnet, dass** die geschlossene Bodenstruktur im Bereich der Wandleranordnung (10) bezüglich dem Rest der Bodenstruktur vorsteht.

37. Vorrichtung nach einem der Ansprüche 24 bis 36, **dadurch gekennzeichnet, dass** sich wenigstens eine Düsenanordnung (24, 26) und die Wandleranordnung (10) parallel zueinander erstrecken.

38. Vorrichtung nach einem der Ansprüche 24 bis 37, **gekennzeichnet durch** eine Steuereinrichtung zum Ansteuern der Wandler (29) als Ultra- oder Megaschallsensor oder als Ultra- oder Megaschallsender.

39. Düseneinheit (1) mit wenigstens einer langgestreckten Düsenanordnung (24, 26), einer benachbart zur Düsenanordnung angeordnete Ultra- oder Megaschall-Wandleranordnung (10), die aus einer Vielzahl von Ultra-oder Megaschall-Wandlern (29) gebildet ist, und Wandler mit unterschiedlichen Resonanzfrequenzen aufweist, wobei die Düsenanordnung (24, 26) und die Wandleranordnung (10) in dieselbe Richtung weisen und eine geschlossene Bodenstruktur der Düseneinheit (1) bilden, und einer Steuervorrichtung zum einzelnen und/oder gruppenweisen Ansteuern der Vielzahl von Wandlern (29).

40. Düseneinheit (1) nach Anspruch 39, **gekennzeichnet durch** wenigstens eine weitere langgestreckte Düsenanordnung (26, 24), wobei die Wandleranordnung (10) zwischen den wenigstens zwei langestreckten Düsenanordnungen (24, 26) angeordnet ist.

41. Düseneinheit (1) nach Anspruch 39 oder 40, **dadurch gekennzeichnet, dass** wenigstens eine langgestreckte Düsenanordnung (24, 26) zu einer Mittelebene der Wandleranordnung (10) hin gerichtet ist.

42. Düseneinheit (1) nach einem der Ansprüche 39 bis 41, **dadurch gekennzeichnet, dass** die Vielzahl von Wandlern (29), jeweils benachbart zueinander, in einer Reihe oder in Form einer Matrix angeordnet ist.

43. Düseneinheit (1) nach einem der Ansprüche 39 bis 42, **dadurch gekennzeichnet, dass** die Wandleranordnung (10) und wenigstens eine Düsenanordnung (24, 26) parallel zueinander sind.

44. Verfahren zum Behandeln von Substraten mit folgenden Verfahrensschritten:
Ausbilden eines Flüssigkeitsfilms auf einem lokalen Oberflächenbereich des Substrats durch eine Düseneinheit mit wenigstens einer langgestreckten Düsenanordnung, wobei über die Längserstreckung der Düsenanordnung hinweg unterschiedliche Flüssigkeiten aufgebracht werden; und
Einbringen von Ultra- oder Megaschall in den Flüssigkeitsfilm, mit einer Ultra- oder Megaschallwandleranordnung, die aus einer Vielzahl von Wandlern aufgebaut ist und Wandler mit unterschiedlichen Resonanzfrequenzen aufweist, wobei die Wandler individuell und/oder in Gruppen mit unterschiedlichen Intensitäten und/oder Frequenzen angesteuert werden.

45. Verfahren nach Anspruch 44 in Kombination mit den Merkmalen eines oder mehrerer der Ansprüche 1 bis 23.

## Claims

1. Method of treating substrates, comprising the following method steps:
forming a liquid film on a local surface region of the substrate, which is to be treated, by a nozzle unit with at least one elongate nozzle arrangement and an ultrasonic or megasonic transducer arrangement, which is arranged adjacent thereto and which is formed from a plurality of transducers and comprises transducers with different resonance frequencies:
bringing at least a part of the ultrasonic or megasonic transducer arrangement into contact with the liquid film; and
introducing ultrasound into the formed liquid film by the ultrasonic or megasonic transducer arrangement, wherein the transducers are activated individually and/or in groups with different intensities and/or frequencies.

2. Method according to claim 1, **characterised in that** the liquid film is formed between a closed base structure of the nozzle unit and the surface region, which is to be treated, of the substrate.

3. Method according to claim 1 or 2, **characterised by** generating a relative movement between the nozzle unit and the substrate for application of the liquid film to different surface regions of the substrate and for introducing the ultrasound into these regions.

4. Method according to claim 3, **characterised in that** the speed of the relative movement between the nozzle unit and the substrate is varied.

5. Method according to claim 4, **characterised in that** the speed of the relative movement is varied in dependence on the position of the nozzle unit relative to the substrate.

6. Method according to any one of the preceding claims, **characterised in that** the introduction of the ultrasound into the liquid film is varied during the treatment.

7. Method according to claim 6, **characterised in that** the introduction of the ultrasound is varied in dependence on the position of the nozzle relative to the substrate.

8. Method according to claim 6 or 7, **characterised in that** the intensity and/or the frequency of the ultrasound introduced into the liquid film is or are varied at least in a subregion of the transducer arrangement.

9. Method according to any one of claims 6 to 8, **characterised in that** the angle of incidence of the ultrasound on the substrate is varied by an inclined setting of the transducer arrangement with respect to a surface of the substrate.

10. Method according to claim 7, **characterised in that** the angle of incidence of the ultrasound with respect to the surface of the substrate is varied between 105° and 75°.

11. Method according to any one of the preceding claims, **characterised in that** the transducers are arranged along a row or in the form of a matrix.

12. Method according to any one of the preceding claims, **characterised in that** the liquid film is formed along a straight line over the entire width of the substrate and the ultrasound is introduced into the liquid film along a straight line over the entire width of the substrate.

13. Method according to any one of the preceding claims, **characterised in that** the introduction of the ultrasound is controlled in different manner over the width of the substrate.

14. Method according to any one of the preceding claims, **characterised in that** the composition of the liquid forming the liquid film is controlled.

15. Method according to any one of the preceding claims, **characterised in that** the nozzle arrangement consists of a plurality of nozzles which are subject to different activation.

16. Method according to claim 14 or 15, **characterised in that** locally different liquids and/or different liquid quantities for formation of the liquid film are applied to the substrate.

17. Method according to any one of the preceding claims, **characterised in that** the liquid film is applied by at least two nozzle arrangements which are arranged on opposite sides of the transducer arrangement.

18. Method according to claim 17, **characterised in that** the nozzles, which are arranged on opposite sides of the transducer arrangement, are acted on by different liquids.

19. Method according to any one of the preceding claims, **characterised in that** during the treatment a mean spacing of 0.2 to 2.0 millimetres, particularly from 0.7 to 1.4 millimetres, is maintained between the transducer arrangement and the surface, which is to be treated, of the substrate.

20. Method according to claim 19, **characterised in that** the mean spacing is varied during the treatment.

21. Method according to any one of the preceding claims, **characterised in that** the liquid forming the liquid film contains a developer or an etchant.

22. Method according to any one of the preceding claims, **characterised in that** the liquid film contains a washing liquid and/or cleaning liquid.

23. Method according to any one of the preceding claims, **characterised in that** at least one of the transducers is activated in such a manner during the introduction of the ultrasound into the liquid film that it operates as a sensor.

24. Device for treatment of substrates (2) with a liquid and ultrasound or megasound, comprising the following:
a nozzle unit (1) with at least one elongate nozzle arrangement (24, 26) for application of a liquid film to the substrate (2) and a transducer arrangement (10), which is arranged adjacent to the nozzle arrangement (24, 26), for introduction of ultrasound or megasound into a liquid film disposed on the substrate (2), wherein the transducer arrangement (10) is formed from a plurality of ultrasonic or megasonic transducers (29), and transducers (29) with different resonance frequencies are provided, and wherein the at least one nozzle arrangement (24, 26) and the transducer arrangement (10) face in the same direction; and
a movement device for the substrate (2) and/or the nozzle unit (1) for positioning the same adjacent to a surface of the substrate (2) in such a manner that the at least one nozzle arrangement (24, 26) and the transducer arrangement (10) are directed onto the surface of the substrate (2) at a defined spacing, and the transducer arrangement (10) contacts a liquid film formed on the surface of the substrate (2); and
a control device for activation of the plurality of transducers (29) individually and/or in groups.

25. Device according to claim 24, **characterised by** a control device for controlling the movement device in such a manner that the nozzle arrangement (24, 26) and the transducer arrangement (10) are moved at a defined spacing over the surface of the substrate (2).

26. Device according to claim 24 or 25, **characterised by** at least one further elongate nozzle arrangement (26, 24), wherein the transducer arrangement (10) is arranged between at least two elongate nozzle arrangements (24, 26).

27. Device according to claim 26, **characterised in that** at least one of the elongate nozzle arrangements (24, 26) is directed towards a centre plane of the transducer arrangement (10).

28. Device according to any one of claims 24 to 27, **characterised in that** the transducers (29) of the plurality are respectively arranged adjacent to one another in a row or in the form of a matrix.

29. Device according to any one of claims 24 to 28, **characterised by** a control device for changing the frequency and/or energy applied to the transducers (29).

30. Device according to any one of claims 24 to 29, **characterised by** a device for setting an angle between a surface of the transducer arrangement (10) and a surface of the substrate (2).

31. Device according to claim 30, wherein the angle is settable between 0 and plus or minus 15°.

32. Device according to any one of claims 24 to 31, **characterised in that** the defined mean spacing is settable between 0.2 and 2 millimetres, particularly between 0.7 and 1.4 millimetres.

33. Device according to any one of claims 24 to 32, **characterised by** a device for supplying liquid to the at least one nozzle arrangement (24, 26).

34. Device according to claim 33, **characterised by** a control device for providing different liquids for different nozzle arrangements (24, 26) and/or different outlet nozzles of the nozzle arrangement or arrangements (24, 26).

35. Device according to any one of claims 24 to 34, **characterised in that** the at least one nozzle arrangement (24, 26) and the transducer arrangement (10) are provided in or at a common main body (4) and form a closed base structure.

36. Device according to claim 35, **characterised in that** the closed base structure protrudes in the region of the transducer arrangement (10) with respect to the rest of the base structure.

37. Device according to any one of claims 24 to 36, **characterised in that** at least one nozzle arrangement (24, 26) and the transducer arrangement (10) extent parallel to one another.

38. Device according to any one of claims 24 to 37, **characterised by** a control device for activation of the transducers (29) as an ultrasonic or a megasonic sensor or as an ultrasonic or a megasonic transmitter.

39. Nozzle unit (1) with at least one elongate nozzle arrangement (24, 26), an ultrasonic or megasonic transducer arrangement (10), which is arranged adjacent to the nozzle arrangement and which is formed from a plurality of ultrasonic or megasonic transducers (29) and comprises transducers with different resonance frequencies, wherein the nozzle arrangement (24, 26) and the transducer arrangement (10) face in the same direction and form a closed base structure of the nozzle unit (1), and a control device for activation of the transducers (29) individually and/or in groups.

40. Nozzle unit (1) according to claim 39, **characterised by** at least one further elongate nozzle arrangement (26, 24), wherein the transducer arrangement (10) is arranged between the at least two elongate nozzle arrangements (24, 26).

41. Nozzle unit (1) according to claim 39 or 40, **characterised in that** at least one elongate nozzle arrangement (24, 26) is directed towards a centre plane of the transducer arrangement (10).

42. Nozzle unit (1) according to any one of claims 39 to 41, **characterised in that** the transducers (29) of the plurality are arranged respectively adjacent to one another in a row or in the form of a matrix.

43. Nozzle unit (1) according to any one of claims 39 to 42, **characterised in that** the transducer arrangement (10) and at least one nozzle arrangement (24, 26) are parallel to one another.

44. Method of treating substrates, comprising the following method steps:
forming a liquid film on a local surface region of the substrate by a nozzle unit with at least one elongate nozzle arrangement, wherein different liquids are applied over the length direction of the nozzle arrangement; and
introducing ultrasound or megasound into the liquid film by an ultrasonic or a megasonic transducer arrangement which is formed from a plurality of transducers and comprises transducers with different resonance frequencies, wherein the transducers are activated individually and/or in groups with different intensities and/or frequencies.

45. Method according to claim 44 in combination with the features of one or more of claims 1 to 23.

## Revendications

1. Procédé pour le traitement de substrats, comportant les étapes:
- formation d'un film de liquide sur une zone superficielle locale du substrat à traiter, au moyen d'une unité de buses avec au moins un système de buses allongé et un système de transducteurs à ultrasons ou mégasons, agencé au voisinage de ce dernier et formé par une pluralité de transducteurs et comportant des transducteurs avec des fréquences de résonance différentes;
- mise en contact d'au moins une partie du système de transducteurs à ultrasons ou mégasons avec le film de liquide; et
- introduction d'un ultrason dans le film de liquide réalisé, au moyen du système de transducteurs à ultrasons ou mégasons, les transducteurs étant commandés individuellement et/ou en groupes avec des intensités et/ou des fréquences différentes.

2. Procédé selon la revendication 1, **caractérisé en ce que** le film de liquide est formé entre une structure de fond fermée de l'unité de buses et la zone superficielle à traiter du substrat.

3. Procédé selon la revendication 1 ou 2, **caractérisé par** la réalisation d'un mouvement relatif entre l'unité de buses et le substrat pour déposer le film de liquide sur différentes zones superficielles du substrat et pour introduire l'ultrason dans lesdites zones.

4. Procédé selon la revendication 3, **caractérisé en ce que** l'on fait varier la vitesse du mouvement relatif entre l'unité de buses et le substrat.

5. Procédé selon la revendication 4, **caractérisé en ce que** la vitesse du mouvement relatif est modulée en fonction de la position de l'unité de buses par rapport au substrat.

6. Procédé selon l'une quelconque des revendications précédentes, **caractérisé en ce que** l'introduction de l'ultrason dans le film de liquide est modulée pendant le traitement.

7. Procédé selon la revendication 6, **caractérisé en ce que** l'introduction de l'ultrason dans le film de liquide est modulée en fonction de la position de l'unité de buses par rapport au substrat.

8. Procédé selon la revendication 6 ou 7, **caractérisé en ce que** l'intensité et/ou la fréquence de l'ultrason introduit dans le film de liquide sont modulées au moins dans une zone partielle du système de transducteurs.

9. Procédé selon l'une quelconque des revendications 6 à 8, **caractérisé en ce que** l'angle d'incidence de l'ultrason sur le substrat est modulé sous l'effet d'un positionnement incliné du système de transducteurs par rapport à une surface du substrat.

10. Procédé selon la revendication 7, **caractérisé en ce que** l'angle d'incidence de l'ultrason par rapport à la surface du substrat est modulé entre 105° et 75°

11. Procédé selon l'une quelconque des revendications précédentes, **caractérisé en ce que** les transducteurs sont disposés sur une rangée ou sous la forme d'une matrice.

12. Procédé selon l'une quelconque des revendications précédentes, **caractérisé en ce que** le film de liquide est formé le long d'une droite sur toute la largeur du substrat, et l'ultrason est introduit dans le film de liquide le long d'une droite sur toute la largeur du substrat.

13. Procédé selon l'une quelconque des revendications précédentes, **caractérisé en ce que** l'introduction de l'ultrason est commandée différemment sur toute la largeur du substrat.

14. Procédé selon l'une quelconque des revendications précédentes, **caractérisé en ce que** la composition du liquide formant le film de liquide est contrôlée.

15. Procédé selon l'une quelconque des revendications précédentes, **caractérisé en ce que** le système de buses est formé par une pluralité de buses qui sont commandées différemment.

16. Procédé selon la revendication 14 ou 15, **caractérisé en ce que** des liquides localement différents et/ou des quantités de liquide différentes sont déposés sur le substrat pour former le film de liquide.

17. Procédé selon l'une quelconque des revendications précédentes, **caractérisé en ce que** le film de liquide est déposé par au moins deux systèmes de buses, qui sont disposés sur des côtés opposés du système de transducteurs.

18. Procédé selon la revendication 17, **caractérisé en ce que** les buses, disposées sur des côtés opposés du système de transducteurs, sont alimentées avec des liquides différents.

19. Procédé selon l'une quelconque des revendications précédentes, **caractérisé en ce qu'**une distance moyenne de 0,2 à 2,0 mm, en particulier de 0,7 à 1,4 mm, est maintenue pendant le traitement entre le système de transducteurs et la surface à traiter du substrat.

20. Procédé selon la revendication 19, **caractérisé en ce que** l'on fait varier la distance moyenne pendant le traitement.

21. Procédé selon l'une quelconque des revendications précédentes, **caractérisé en ce que** le liquide formant le film de liquide contient un révélateur ou un agent de gravure.

22. Procédé selon l'une quelconque des revendications précédentes, **caractérisé en ce que** le film de liquide contient un liquide de rinçage et/ou de nettoyage.

23. Procédé selon l'une quelconque des revendications précédentes, **caractérisé en ce que**, pendant l'introduction de l'ultrason dans le film de liquide, au moins un des transducteurs est commandé au moins de temps en temps, de telle sorte qu'il remplit la fonction d'un capteur.

24. Dispositif pour le traitement de substrats avec un liquide et un ultrason ou mégason, lequel comporte les éléments suivants:
- une unité de buses (1) avec au moins un système de buses (24, 26) allongé, destiné à déposer un film de liquide sur le substrat (2), et un système de transducteurs (10), agencé au voisinage du système de buses (24, 26) et destiné à introduire un ultrason ou mégason dans un film de liquide situé sur le substrat (2), le système de transducteurs (10) étant formé par une pluralité de transducteurs à ultrasons ou mégasons (29), et il est prévu des transducteurs (29) avec des fréquences de résonance différentes, et ledit au moins un système de buses (24, 26) et le système de transducteurs (10) étant dirigés dans la même direction; et
- un dispositif de déplacement pour le substrat (2) et/ou l'unité de buses (1) pour le positionnement de cette dernière au voisinage d'une surface du substrat (2), de telle sorte que ledit au moins un système de buses (24, 26) et le système de transducteurs (10) sont dirigés vers la surface du substrat (2) à une distance définie, et le système de transducteurs (10) est mis en contact avec un film de liquide formé sur la surface du substrat (2); et
- un dispositif de commande destiné à commander individuellement et/ou en groupes la pluralité de transducteurs (29).

25. Dispositif selon la revendication 24, **caractérisé par** un dispositif de commande destiné à commander le dispositif de déplacement de telle sorte que le système de buses (24, 26) et le système de transducteurs (10) sont déplacés à une distance définie au-dessus de toute la surface du substrat (2).

26. Dispositif selon la revendication 24 ou 25, **caractérisé par** au moins un système de buses (26, 24) allongé supplémentaire, le système de transducteurs (10) étant disposé entre au moins deux systèmes de buses (24, 26) allongés.

27. Dispositif selon la revendication 26, **caractérisé en ce qu'**au moins un des systèmes de buses (24, 26) allongés est dirigé vers un plan médian du système de transducteurs (10).

28. Dispositif selon l'une quelconque des revendications 24 à 27, **caractérisé en ce que** la pluralité des transducteurs (29), respectivement adjacents entre eux, sont agencés en une rangée ou sous la forme d'une matrice.

29. Dispositif selon l'une quelconque des revendications 24 à 28, **caractérisé par** un dispositif de commande destiné à moduler la fréquence et/ou l'énergie appliquée aux transducteurs (29).

30. Dispositif selon l'une quelconque des revendications 24 à 29, **caractérisé par** un dispositif destiné à ajuster un angle entre une surface du système de transducteurs (10) et une surface du substrat (2).

31. Dispositif selon la revendication 30, dans lequel l'angle peut être ajusté entre 0 et ± 15°.

32. Dispositif selon l'une quelconque des revendications 24 à 31, **caractérisé en ce que** la distance moyenne définie peut être ajustée entre 0,2 et 2 mm, en particulier entre 0,7 et 1,4 mm.

33. Dispositif selon l'une quelconque des revendications 24 à 32, **caractérisé par** un dispositif destiné à fournir un liquide audit au moins un système de buses (24, 26).

34. Dispositif selon la revendication 33, **caractérisé par** un dispositif de commande destiné à mettre à disposition des liquides différents pour différents systèmes de buses (24, 26) et/ou différentes buses de sortie du/des système(s) de buses (24, 26).

35. Dispositif selon l'une quelconque des revendications 24 à 34, **caractérisé en ce que** ledit au moins un système de buses (24, 26) et le système de transducteurs (10) sont prévus dans/sur un corps principal (4) commun et forment une structure de fond fermée.

36. Dispositif selon la revendication 35, **caractérisé en ce que** dans la zone du système de transducteurs (10), la structure de fond fermée s'avance en saillie par rapport au reste de la structure de fond.

37. Dispositif selon l'une quelconque des revendications 24 à 36, **caractérisé en ce qu'**au moins un système de buses (24, 26) et le système de transducteurs (10) sont parallèles entre eux.

38. Dispositif selon l'une quelconque des revendications 24 à 37, **caractérisé par** un dispositif de commande destiné à commander les transducteurs (29) en tant que capteur à ultrasons ou mégasons ou en tant qu'émetteur à ultrasons ou mégasons.

39. Unité de buses (1) comportant au moins un système de buses (24, 26) allongé, un système de transducteurs à ultrasons ou mégasons (10), agencé au voisinage du système de buses et formé par une pluralité de transducteurs à ultrasons ou mégasons (29) et comportant des transducteurs avec des fréquences de résonance différentes, le système de buses (24, 26) et le système de transducteurs (10) étant dirigés dans la même direction et formant une structure de fond fermée de l'unité de buses (1), et un dispositif de commande destiné à commander individuellement et/ou en groupes la pluralité de transducteurs (29).

40. Unité de buses (1) selon la revendication 39, **caractérisée par** au moins un système de buses (26, 24) allongé supplémentaire, le système de transducteurs (10) étant disposé entre lesdits au moins deux systèmes de buses (24, 26) allongés.

41. Unité de buses (1) selon la revendication 39 ou 40, **caractérisée en ce qu'**au moins un des systèmes de buses (24, 26) allongés est dirigé vers un plan médian du système de transducteurs (10).

42. Unité de buses (1) selon l'une quelconque des revendications 39 à 41, **caractérisée en ce que** la pluralité de transducteurs (29), respectivement adjacents entre eux, sont agencés en une rangée ou sous la forme d'une matrice.

43. Unité de buses (1) selon l'une quelconque des revendications 39 à 42, **caractérisée en ce que** le système de transducteurs (10) et au moins un système de buses (24, 26) sont parallèles entre eux.

44. Procédé pour le traitement de substrats, comportant les étapes:
- formation d'un film de liquide sur une zone superficielle locale du substrat, au moyen d'une unité de buses avec au moins un système de buses allongé, des liquides différents étant déposés sur toute la dimension longitudinale du système de buses; et
- introduction de l'ultrason ou du mégason dans le film de liquide au moyen d'un système de transducteurs à ultrasons ou mégasons, qui est formé par une pluralité de transducteurs et comporte des transducteurs avec des fréquences de résonance différentes, les transducteurs étant commandés individuellement et/ou en groupes avec des intensités et/ou des fréquences différentes.

45. Procédé selon la revendication 44 en combinaison avec les caractéristiques de l'une ou de plusieurs des revendications 1 à 23.
